# EUROPEAN PATENT APPLICATION

(11) **EP 4 570 566 A1**
(43) Date of publication of application: **18.06.2025**
(21) Application number: 24218062.8
(22) Date of filing: 06.12.2024
(51) Int. Cl.: B60L 3/00, B60L 3/04, B60L 58/30, G01R 31/54

(54) **HIGH-VOLTAGE COMPONENT AND METHOD OF USE THEREOF**

(30) Priority: 08.12.2023 SE 2351408
(71) Applicant: Volvo Truck Corporation, 405 08 Göteborg (SE)
(72) Inventor: Cacic, Toni, 422 41 Hisings Backa (SE); Arya, Pranav, 412 85 Göteborg (SE); Blanc, Ricard, 431 68 Mölndal (SE)
(74) Representative: Valea AB

(57) **Abstract**

A high-voltage (HV) or traction voltage component and a method of use thereof is provided for an electric, fuel cell, or hybrid vehicle. The HV component is reconfigurable to be included in a centralized HVIL system or reconfigurable to be included in a de-centralized HVIL system. The HV component comprises an internal Hazardous Voltage Interlock Loop (HVIL) system comprising a signal continuity detection circuit comprising a signal detector and a high-voltage connector. A first signal generator of the internal HVIL system is configured to generate a signal in the signal continuity detection circuit and is reconfigurable to either be connected to or disconnected from an external HVIL system of the vehicle. A signal communication interface of the HV component is configurable to provide an electrical connection between the signal continuity detection circuit of the internal HVIL system and the external HVIL system, and is configurable to allow the first signal generator to be disconnected from the signal continuity detection circuit.

## Description

### TECHNICAL FIELD

The disclosure relates generally to a reconfigurable high-voltage component for a vehicle that may be interchangeably used in a high-voltage, or hazardous voltage, interlock loop (HVIL) systems of different configurations.

The disclosure can be applied in heavy-duty vehicles, such as trucks, buses, and construction equipment, as well as in gensets.

### BACKGROUND

In systems in which electrical current is transmitted through circuits, such as, e.g., electric and hybrid electric vehicles, a hazardous voltage interlock loop (HVIL) system may be used that provides a safeguard for service personnel and any other user of the vehicle from high voltages which may be used in such systems.

A high-voltage (HV) component, also referred to as a traction voltage component, may have physical barriers such as e.g. a lid, a lock, an access cover, a shell, or any type of an enclosure that is designed, among other functions, to prevent a person accessing the HV component from being exposed to high voltage. The internal HVIL system, also referred to sometimes as an HVIL loop, comprises a signal detection circuit e.g. a low-voltage circuit that has a signal circulating therethrough to detect when a continuity or integrity of the signal is interrupted. For example, when a cover of a HV component is open, an interlocked circuit loop of the internal HVIL may be broken, which in turn causes a flow of a HV current through the system be stopped before access to the HV component is permitted.

An HVIL system may be implemented in different ways. For example, in a so-called de-centralized HVIL system, each HV component of the vehicle relies on an internal current generator and reports failures of a low-voltage circuit of an internal HVIL system to an external control system. In a so-called centralized HVIL system, each HV component of the vehicle relies on an external current generator of an external HVIL system that is monitored by an external control unit. Thus, a HV component may be of a type that fits the centralized HVIL system. Another type of a HV component is used in vehicles deploying a de-centralized HVIL system. Accordingly, multiple types of HV components are required for applications employing different HVIL systems.

### SUMMARY

Aspects of the present disclosure relate to implementation of a hazardous voltage interlock loop (HVIL) system, also referred to as a high-voltage interlock loop (HVIL) system. A high-voltage or traction voltage component in accordance with examples of the present disclosure is reconfigurable to fit a vehicle implementing a centralized HVIL system in which an internal HVIL system of the HV component forms part of an external, centralized HVIL system. The HV component is also reconfigurable such that it may be used in a vehicle implementing a de-centralized HVIL system in which an internal HVIL system of the HV component does not form part of the external de-centralized HVIL system. Accordingly, the same type of an HV component may be used in multiple applications, regardless of whether an application deploys a centralized HVIL system or a de-centralized HVIL system. In this way, the same hardware component, i.e. the HV component in accordance with examples of the present disclosure, may advantageously be used for applications deploying different types of HVIL systems. Furthermore, the reconfiguration of the HV component may be reversible, such that it, in some examples, HW component may be moved from a vehicle with a centralized HVIL system to a vehicle with a de-centralized HVIL system. In some examples, the HW component may be moved from a vehicle with a de-centralized HVIL system to a vehicle with a centralized HVIL system.

In an aspect, a high-voltage component for a vehicle is provided that comprises an internal Hazardous Voltage Interlock Loop (HVIL) system comprising: a signal continuity detection circuit comprising a signal detector configured to detect a value of a signal in the signal continuity detection circuit; and a high-voltage connector that includes a signal path that is interrupted when a continuity of the signal in the signal continuity detection circuit is breached. The HVIL system also comprises a first signal generator that is configured to generate a signal in the signal continuity detection circuit and that is reconfigurable to either be connected to or disconnected from an external HVIL system; and a signal communication interface configurable to provide an electrical connection between the signal continuity detection circuit of the internal HVIL system and the external HVIL system, and configurable to allow the first signal generator to be disconnected from the signal continuity detection circuit.

The technical benefits include allowing manufacture and use in a vehicle of a HV component that fits either a vehicle with a centralized HVIL system or a vehicle with a de-centralized HVIL system. This saves production, service, and maintenance costs and time.

In some examples, the signal detector may be configured to be connected to an external interlocked circuit of the external HVIL system to receive a signal from a second signal generator located in the external interlocked circuit.

In some examples, the high-voltage connector may comprise a signal connector and a power connector, wherein the signal connector is configured to be opened before the power connector is opened.

In some examples, the high-voltage component comprises a fuel cell system.

In some examples, the signal continuity detection circuit may comprise at least one additional signal detector. In some examples, the at least one additional signal detector may be configured to detect which one of at least two high-voltage components including the high-voltage component, connected to the external HVIL system, is causing the breach of the continuity of the signal.

In some examples, the HV component may comprise an access component that is configured to cause the continuity of the signal in the signal continuity detection circuit be breached when the access component is moved from a first configuration to a second configuration. The access component may be, e.g., a lid, a protective cover, a shell, a connector, etc.

In some examples, when the first signal generator is reconfigured to be connected to the signal continuity detection circuit, and when the continuity of the signal is breached, the internal HVIL system is configured to generate and send a message to the vehicle, the message informing the vehicle of the breach of the continuity of the signal. In some examples, the internal HVIL system is configured to receive, in response to the message, receive an instruction from the vehicle regarding an action responsive to the breach of the continuity of the signal.

In some examples, the high-voltage component is reconfigurable to be included in a centralized HVIL system or reconfigurable to be included in a de-centralized HVIL system.

In an aspect, a high-voltage component assembly of a vehicle is provided, the high-voltage component assembly comprising at least one high-voltage component in accordance with examples of the present disclosure. In some examples, the high-voltage component assembly may comprise an external HVIL system comprising an external signal continuity detection circuit configured to electrically couple to an internal signal continuity detection circuit of each of the at least one high-voltage component.

In an aspect, a high-voltage component is provided that is reconfigurable to be included in a centralized HVIL system or reconfigurable to be included in a de-centralized HVIL system.

In an aspect, a vehicle is provided that comprises at least one high-voltage component in accordance with examples of the present disclosure.

In an aspect, a vehicle is provided that comprises at least one high-voltage component assembly in accordance with examples of the present disclosure.

In an aspect, a method for configuring a high-voltage component for a vehicle is provided, the method comprises configuring the high-voltage component so that a first signal generator of an internal Hazardous Voltage Interlock Loop, HVIL, system of the high-voltage component is connected to a signal continuity detection circuit of the internal HVIL system, wherein the first signal generator is configured to generate a signal for the signal continuity detection circuit, wherein the first signal generator is reconfigurable to be non-functional and disconnected from the signal continuity detection circuit, and wherein the signal continuity detection circuit comprises a high-voltage connector that enables a signal detector to detect when a continuity of the signal continuity detection circuit is breached.

In some examples, the method further comprises removing the high-voltage component from the vehicle and installing the high-voltage component on another vehicle which comprises reconfiguring the first signal generator to be non-functional and disconnected from the signal continuity detection circuit; and connecting the signal continuity detection circuit of the internal HVIL system to an external HVIL system, so that the signal continuity detection circuit receives the signal from a second signal generator of the external HVIL system.

In an aspect, a method for configuring a high-voltage component for a vehicle is provided, the method comprises configuring the high-voltage component so that a first signal generator of an internal Hazardous Voltage Interlock Loop, HVIL, system of the high-voltage component is disconnected from a signal continuity detection circuit of the internal HVIL system and is non-functional, wherein the first signal generator is reconfigurable to be connectable to the signal continuity detection circuit, and wherein the signal continuity detection circuit comprises a high-voltage connector that enables a signal detector to detect when a continuity of the signal continuity detection circuit is breached; and connecting the signal continuity detection circuit of the internal HVIL system to an external HVIL system, so that the signal continuity detection circuit receives the signal from a second signal generator of the external HVIL system.

In some examples, the method further comprises removing the high-voltage component from the vehicle and installing the high-voltage component on another vehicle which comprises reconfiguring the first signal generator of the internal HVIL system to be connected to the signal continuity detection circuit so that the first signal generator is functional and generates a signal for the signal continuity detection circuit of the internal HVIL system.

Additional features and advantages are disclosed in the following description, claims, and drawings. Furthermore, additional advantages will be readily apparent from the present disclosure to those skilled in the art or recognized by practicing the disclosure as described herein. There are also disclosed herein control units, computer program products, and computer-readable media associated with the above discussed technical effects and corresponding advantages.

### BRIEF DESCRIPTION OF THE DRAWINGS

With reference to the appended drawings, below follows a more detailed description of aspects of the disclosure cited as examples.
**FIG. 1A** illustrates a side view of an example of a vehicle which employs a centralized HVIL system.
**FIG. 1B** illustrates a side view of an example of a vehicle which employs a de-centralized HVIL system.
**FIG. 2** is a block diagram illustrating an example of a vehicle comprising a HV component for a centralized HVIL system, as known in the art.
**FIG. 3** is a block diagram illustrating an example of a vehicle comprising a HV component for a de-centralized HVIL system, as known in the art.
**FIG. 4** is a block diagram illustrating an example of a vehicle comprising a HV component reconfigured to be used in a centralized HVIL system, in accordance with examples of the present disclosure.
**FIG. 5** is a block diagram illustrating an example of the HV component of FIG. 4 that is reconfigured to be used in a de-centralized HVIL system, in accordance with examples of the present disclosure.

### DETAILED DESCRIPTION

A vehicle such as, e.g., a fuel cell vehicle, an electric vehicle, or a hybrid vehicle, includes multiple traction voltage components, also interchangeably referred to herein as high-voltage (HV) or traction voltage components. The vehicle with HV components typically employs a hazardous voltage interlock loop (HVIL) system, which provides a safety functionality that protects people during the assembly, repair, maintenance and operation of the vehicle. The HVIL system comprises a low-voltage loop or circuit that monitors HV components such that, if a low-voltage HVIL signal on the low-voltage circuit is interrupted, this indicates that there is an issue with a high-voltage system of one or more HV components.

As used herein, a high-voltage (HV) component refers to an electric component or circuit that can operate in a voltage range of > 60 V and ≤ 1500 V DC, or in a voltage range > 30 V and ≤ 1000 V AC root mean square (rms). The high-voltage component may be a component classified as a voltage class "B" component according to ISO 6469-3. Non-limiting examples of HV components include a fuel cell system (FCS), a motor, a junction box, an inverter, and any other type of a component in a vehicle that may operate in the voltage range as defined above. As used herein, low voltage refers to a voltage below 60V DC and below 30 V AC.

When there is an attempt to access the HV component, for example, its protective cover or lid is opened, or a connector such as a plug is pulled out to disconnect the HV component from the vehicle, a continuity or integrity of a signal in a signal continuity detection circuit of an internal HVIL system may be breached, thereby indicating that traction voltage to the HV component needs to be interrupted. When a lid or a protective cover of the HV component is being open, there is a danger that a person can come in contact with hazardous voltage. In some cases, during a course of a repair or maintenance of the HV component, when unplugging a connector of the HV component, an electric arc effect may occur e.g. a loud flash which may startle a person such as e.g. a maintenance personnel. This may be dangerous when the person is working above the ground such as e.g. a risk of a fall takes place. There is also a burn risk because a temperature of the high-voltage connector may become high enough. Also, the arc is hot and the heat from the arc i.e. the air gap can burn the person's skin.

The internal HVIL system of the HV component, and in some implementations an external HVIL system of the vehicle are thus designed so as to reduce a risk of the arc effect, in addition to preventing premature access to the HV component i.e. before power is interrupted.

Accordingly, aspects in accordance with examples of the present disclosure provide a traction voltage or HV component that is reconfigurable to be included in a centralized HVIL system or reconfigurable to be included in a de-centralized HVIL system. In some examples, the reconfiguration of the HV component may be reversible such that the HV component may be removed from the vehicle with a centralized HVIL system to a vehicle with a de-centralized HVIL system.

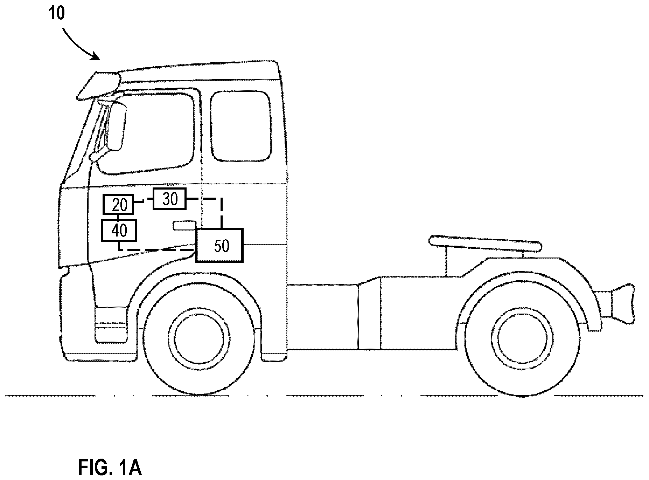

**FIG. 1A** depicts a side view of a vehicle 10 in which examples of the present disclosure may be implemented. The vehicle 10 is shown as a truck, such as a heavy-duty truck for towing one or more trailers (not shown). The vehicle 10 may be an electric vehicle, e.g., a fuel cell electric vehicle (FCEV) or a hybrid vehicle. It should be appreciated that the present disclosure is not limited to any other specific type of vehicle, and may be used for any other type of vehicle, such as a bus, construction equipment, e.g. a wheel loader or an excavator, a passenger car, an aircraft, and a marine vessel. The present disclosure is also applicable for other applications not relating to vehicles, including stationary applications.

FIG. 1A schematically illustrates an example of the vehicle 10 comprising a centralized HVIL system comprising first, second, and third HV components 20, 30, 40. An internal HVIL system of each of the first, second, and third components 20, 30, 40 is part of an external HVIL system of the vehicle e.g. the centralized HVIL system, such that a vehicle controller 50, e.g., an electronic control unit (ECU), is aware of faults on each of the HV component's internal HVIL system, due to the nature of the design of the centralized HVIL system.

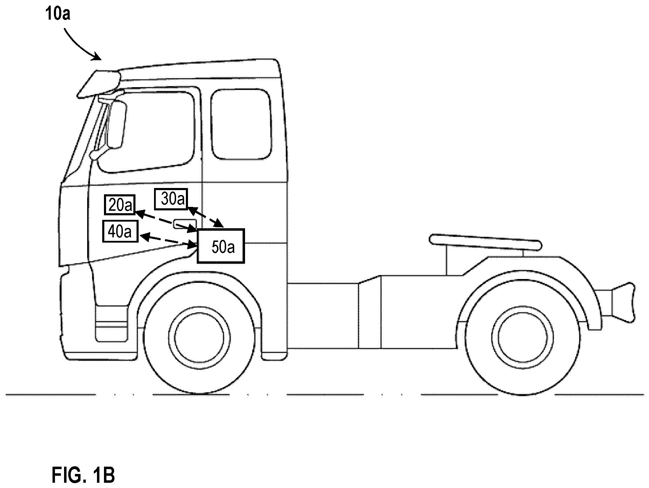

**FIG. 1B** schematically illustrates an example of the vehicle 10a which may be similar to the vehicle 10 of FIG. 1A but which comprises a de-centralized HVIL system comprising first, second, and third HV components 20a, 30a, 40a. An internal HVIL system of each of the first, second, and third components 20a, 30a, 40a communicates faults on the internal HVIL system to a vehicle controller 50a e.g. an ECU.

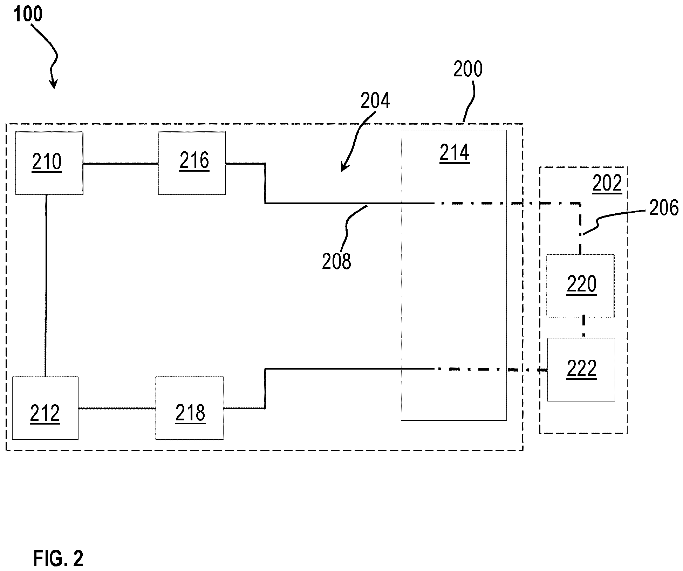

**FIG. 2** illustrates in more detail an example of a vehicle 100 that employs a centralized HVIL system, wherein the vehicle 100 of FIG. 2 may be similar to e.g. vehicle 10 of FIG. 1. As shown in FIG. 2, the vehicle 100 comprises a HV component 200 that communicates with an ECU 202, also referred to as a master ECU, of the vehicle 100. In some examples, the vehicle 100 may be a fuel cell vehicle and the HV component 200 may be a fuel cell system (FCS), a motor, a battery, an inverter, an adapter, or any other HV component. In some examples, the HV component 200 comprises a FCS.

As shown in FIG. 2, the HV component 200 comprises an internal HVIL system 204, which may be considered to be part of an external HVIL system 206 of the vehicle 100. The internal HVIL system 204 comprises a signal continuity detection circuit 208 in the form of an interlocked circuit loop. The signal continuity detection circuit 208 comprises a signal detector 210 configured to detect a value of a signal in the signal continuity detection circuit 208, a high-voltage connector 212 that includes a signal path that is interrupted when a continuity of the signal in the signal continuity detection circuit is breached, and a signal communication interface 214. The signal communication interface 214 is configurable to provide an electrical connection between the signal continuity detection circuit 208 of the internal HVIL system 204 and the external HVIL system 206.

The HV component 200 may optionally include at least one additional signal detector, shown by way of example as first and second additional signal detectors 216, 218 that are configured to detect which of HV components connected to the HVIL system is causing the breach of the continuity of the signal.

In the centralized HVIL system shown in FIG. 2, the signal continuity detection circuit 208 of the internal HVIL system 204 of the HV component 200 uses signal, e.g., current or voltage, produced by a signal generator 220 that is external to the HV component 200. The signal generator 220 is configured to generate the signal that is pushed through the signal continuity detection circuit 208. The signal generator 220 is shown as part of the master ECU 202 for illustration purposes only, to show that, in a centralized HVIL system, the signal generator generating a signal for the internal HVIL system of the HV component is positioned outside of the HV component. The signal generated by the signal generator 220 circulates through the signal continuity detection circuit 208 configured as an interlocked loop circuit, and an interruption of the continuity of the signal through the loop is detected as an interruption or breach or fault on the signal continuity detection circuit 208. This, in turn, indicates that the high-voltage connector 212 is disconnected, loose, or damaged. This is detected, as a signal drop, by both the signal detector 210 of the HV component 200 as well as by a second signal detector 222 of the external HVIL system 206.

The external HVIL system 206 is referred to as a centralized HVIL system because it is electrically connected to internal HVIL systems of one or more, typically multiple, HV components of the vehicle. The external HVIL system 206, together with the HV components' internal HVIL systems, forms a common, centralized system which is aware of a status of signal continuity detection circuits of the respective HV components. Thus, with reference to FIG. 2, the ECU 202 will detect a fault on the signal continuity detection circuit 208 of the HV component 200, and will immediately, i.e. in real time or close to real time, provide an instruction, signal, or command to the HV component 200 regarding e.g. disconnecting the HV component 200 from the high-voltage power.

The high-voltage connector 212 is configured to electrically and physically couple or mate the HV component 200 to the outside e.g. to a suitable component of the vehicle 100. Although not shown in FIG. 2, as known in the art, the high-voltage connector 212 may comprise, may be included in, or may be associated with an access point or component such as e.g. a housing, cover, lid, shell, or any enclosure that can be movable to allow gaining access to the HV component. Opening or other change in the configuration of the access point or component may cause the high-voltage connector 212 to detect the breach of the continuity of the signal continuity detection circuit 208.

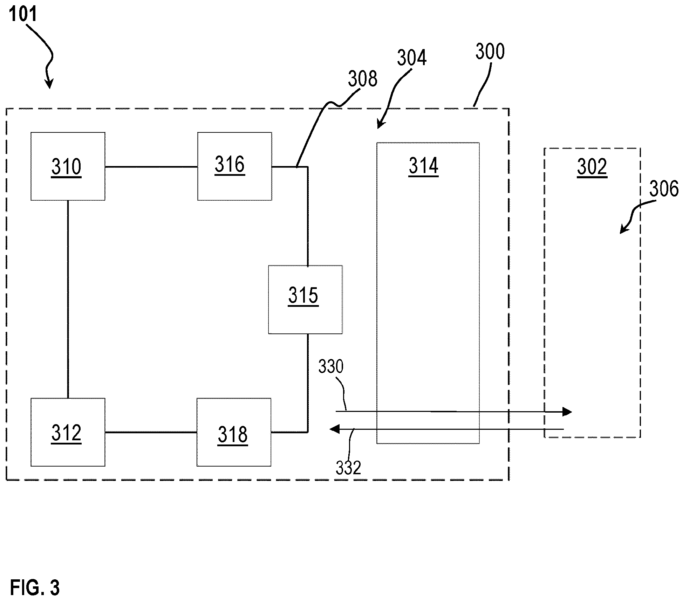

**FIG. 3** illustrates an example of a so-called decentralized HVIL system 306 where an internal HVIL system of an HV component does not form part of an external, vehicle HVIL system. In such an implementation, a signal generator of the internal HVIL system of an HV component is located inside the HV component. When a breach of a continuity of a signal passing through a signal continuity detection circuit of the internal HVIL system of the HV component is detected, e.g, as a fault, information or message about the breach is communicated to the vehicle e.g. to a master ECU. In response, the master ECU informs the HV component to shut down the high voltage or to respond otherwise to the fault.

Thus, FIG. 3 shows a vehicle 101 comprising a HV component 300 that comprises a signal continuity detection circuit 308 of an internal HVIL system 304. The signal continuity detection circuit 308 comprises a signal detector 310, a high-voltage connector 312, and a signal generator 315 that generates a signal for the signal continuity detection circuit 308. Thus, the signal continuity detection circuit 308 relies on the signal generator 315 positioned inside the HV component 300.

The HV component 300 may send an indication or message 330 to a master ECU 302 of the vehicle 101 regarding a fault on the signal continuity detection circuit 308. The HV component 300 may receive from the master ECU 302, in response to the message 330, an instruction 332 regarding whether to disconnect a high-power voltage from the HV component 300.

The HV component 300 includes a signal communication interface 314 e.g. a low-voltage communication interface in some examples, that is configured to provide an electrical connection between the signal continuity detection circuit 308 of the internal HVIL system 304 and the external HVIL system. The signal communication interface 314 includes a communication channel (not shown) configured to allow the high-voltage connector 312 to inform the vehicle of a fault on the signal continuity detection circuit 308. The communication channel may be or may comprise e.g. Controller Area Network (CAN) bus.

Typically, a HV component that fits a centralized HVIL system has a different configuration than a HV component that is suitable for a de-centralized HVIL system. Thus, a manufacturer of a HV component currently needs to manufacture a HV component of at least two different, non-changeable configurations, for vehicles that deploy a centralized HVIL system and a de-centralized HVIL system, respectively. This adds production times and costs. Accordingly, examples of the present disclosure provide a HV component that is reconfigurable, or modular, to fit either a centralized HVIL system or a de-centralized HVIL system of a vehicle in which the HV component is installed. In this way, there is no need to generate different types of the same HV component to fit a centralized HVIL system and a de-centralized HVIL system, since the same HV component may be interchangeably used in either of the HVIL systems. Furthermore, in some implementations, the HV component may be movable from a vehicle having a centralized HVIL system to a vehicle having a de-centralized HVIL system, and vice versa.

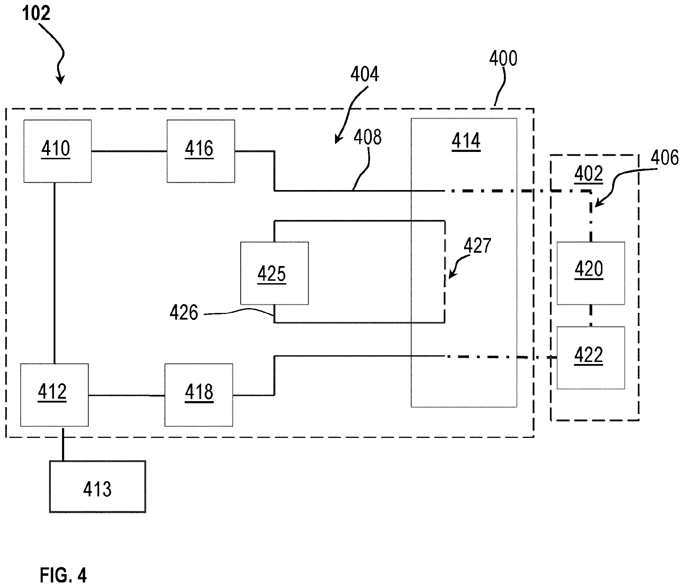

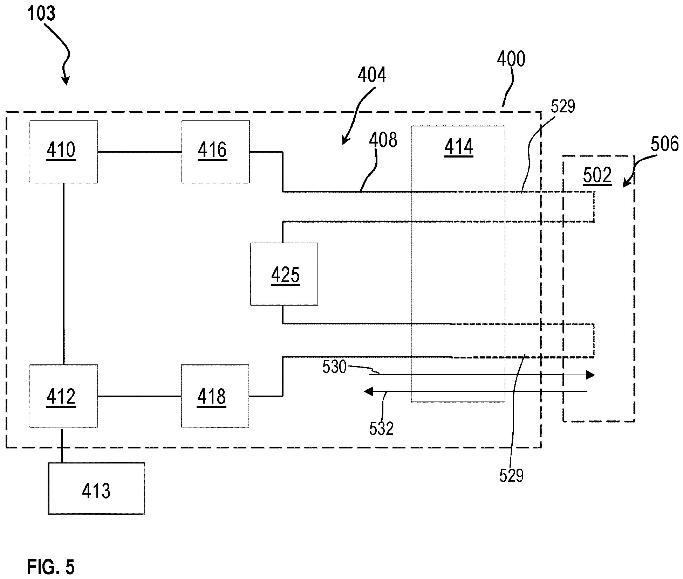

**FIGs. 4** and **5** illustrate a HV device or component 400 in accordance with examples of the present disclosure, which is reconfigurable to be installed on either a centralized HVIL system or a de-centralized HVIL system of a vehicle. The vehicle may be e.g. any of vehicles shown in FIGs. 1A and 1B. The vehicle may be an electric vehicle, a fuel cell vehicle, a hybrid vehicle, or another type of vehicle. FIG. 4 illustrates that the HV component 400 may be reconfigured to be installed on a vehicle 102 that deploys a centralized HVIL system, and FIG. 5 illustrates that the same HV component 400 may be reconfigured to be installed on a vehicle 103 that deploys a de-centralized HVIL system. FIGs. 4 and 5 depict lines, representing electric lines or wires, that illustrate an internal and external signal continuity detection circuits, whereas power connections are not shown.

As shown in FIG. 4, the HV component 400 comprises an internal HVIL system 404 that comprises a signal continuity detection circuit 408. The signal continuity detection circuit 408 comprises a signal detector 410, a high-voltage connector 412, and a signal communication interface 414. The HVIL system 400 comprises a first signal generator 425. The signal detector 410 is configured to detect a value of a signal in the signal continuity detection circuit. The high-voltage connector 412 includes a signal path that is interrupted when a continuity of the signal in the signal continuity detection circuit 408 is breached. The first signal generator 425 is configured to generate the signal in the signal continuity detection circuit 408 and is reconfigurable to either be connected to or disconnected from an external HVIL system. In the example of FIG. 4, the external HVIL system 406 of the vehicle 102 is a centralized HVIL system, and the signal continuity detection circuit 408 forms part of the external HVIL system 406.

The signal communication interface 414 is configurable to provide an electrical connection between the signal continuity detection circuit 408 of the internal HVIL system 404 and the external HVIL system 406, and configurable to allow the first signal generator 425 to be disconnected from the signal continuity detection circuit 408. Thus, as shown in FIG. 4, the first signal generator 425, although present in the HV component 400, is disconnected from the signal continuity detection circuit 408. More particularly, the first signal generator 425 is shown to be locked in a loop circuit 426 in which connections to and from the first signal generator 425 are, e.g., shortened, as shown schematically by a dashed line 427. This may help eliminate possible internal fault codes.

The HV component 400 may be configured such that, in use, the shortening or closing of the loop circuit 426 comprising the first signal generator 425 may be allowed via the signal communication interface 414 that may be configured to provide access to wiring extending from the first signal generator 425. In this way, the first signal generator 425 is reconfigured to be non-functional in the HV component 400, which allows using the HV component 400 in the vehicle 102 deploying the centralized HVIL system which includes a signal generator, referred to herein as a second signal generator 420.

A master or vehicle ECU 402 of the vehicle 102 is configured to control internal components of the vehicle 102, including the HV component 400. In some examples, the ECU 402 may be referred to as a traction voltage monitoring unit. The ECU 402 may be or may include, e.g., a general-purpose processor, an application-specific processor, a circuit with processing components, a distributed group of processing components, a distributed group of computers configured for processing, a field programmable gate array (FPGA), or the like. A processor may be or may include any number of hardware components for performing data or signal processing or executing computer code stored in memory. The memory may be one or more devices for storing data and/or computer code for carrying out or enabling the various methods described herein. The memory may include volatile memory or non-volatile memory. The memory may include database components, object code components, script components, or other types of information structures to support the various activities of the present disclosure. According to an example, any distributed or local memory device may be used with the systems and methods of the present disclosure. According to an example, the memory is coupled in communication with the processor (e.g., via a circuit or other wired, wireless or network connection) and includes computer code for executing one or more processes described herein. The ECU 402 may be included in a controller or control system of the vehicle 102 that comprises various other components.

In the example of FIG. 4, the signal detector 422 of the master ECU 402 may be configured to be connected to an external interlocked circuit of the external HVIL system 406 to receive a signal from the second signal generator 420 located in the external interlocked circuit. The external HVIL system 406 of the vehicle 102 is shown, in part, schematically in FIG. 4 as a dot-dashed line, which also represents the external interlocked circuit of the external HVIL system 406. The external interlocked circuit of the external HVIL system 406 may interchangeably be referred to as an external signal continuity detection circuit. It should be noted that other HV components may be associated with the external HVIL system 406, in a manner similar to the HV component 400, such that the other HV components' internal HVIL systems rely on a signal generated by the second signal generator 420. The external HVIL system 406 includes a second signal detector 422 that is configured to detect an interruption of a continuity of the signal in the signal continuity detection circuit 408. The second signal detector 422 facilitates immediate, or almost immediate detection by the external HVIL system 406 of a fault on the signal continuity detection circuit 408.

The high-voltage connector 412 may comprise a signal connector and a power connector (not shown), wherein the signal connector is configured to be opened or disconnected before the power connector is opened or disconnected. In other words, the signal connector, e.g., signal pins or terminals, may be configured to detect a disconnection in the high-voltage connector 412 before the power connector, e.g., power contacts, detects the disconnection. This may be achieved by, e.g., adjusting a length of the power contacts of the power connector and of the signal pins or pilot contacts of the signal connector. For example, the high-voltage connector 412 may be configured such that the signal pins, passing the signal, may be shorter than the power contacts of the power connector, so that, when the high-voltage connector 412 is disconnected, the power contacts are separated after the pilot contacts are separated.

In some examples, the high-voltage connector 412 may be referred to as a traction voltage (voltage class B) interface towards vehicle. The high-voltage connector 412 may comprise male and female physical connectors that are reversibly mated to close or open the interlocked loop of the signal continuity detection circuit 408. In FIG. 4, the lines, representing a wiring, connected to the high-voltage connector 412, represent a connection to the signal pins inside the high-voltage connector 412.

In some examples, as shown in FIG. 4, the signal continuity detection circuit 408 of the high-voltage component 400 comprises at least one additional signal detector, shown as first and second additional signal detectors 416, 418. The at least one additional signal detector 416, 418 is configured to detect which one of at least two high-voltage components, including the HV component 400, connected to the external HVIL system 406, is causing the breach of the continuity of the signal. The additional signal detectors 416, 418 may be, e.g., voltage detectors. It should be appreciated that, in the centralized configuration or system, the HV component 400 may be included in an interlocked circuit loop comprising multiple HV component, and such circuit or loop may include multiple additional signal detectors. When a breach of a signal continuity is detected on the circuit or loop, the additional signal detectors allow determining which of the HV components has caused the breach.

In some examples, the high-voltage component 400 comprises or is associated with an access component 413 that is configured to cause the continuity of the signal in the signal continuity detection circuit 408 be breached when the access component 413 is moved from a first configuration to a second configuration. The access component 413 may be, for example, a lid, a protective cover, a shell, or any other type of an enclosure that prevents and controls access to the high-voltage component 400. The access component 413 may be moved from the first e.g. closed configuration to the second e.g. open or at least partially open configuration, which may cause a breach of a signal continuity in the signal continuity detection circuit 408. As an example, the access component 413, e.g., a lid or cover may be configured to block access to hazardous voltage, and the lid may include a signal switch or another suitable component configured to open the interlocked circuit loop of the signal continuity detection circuit 408 when the lid is open. The signal switch may be a mechanical switch, or a magnetic switch, or a switch of another suitable type. Regardless of its specific configuration, the switch or another similar feature, may be configured to open or break or interrupt the interlocked circuit loop of the signal continuity detection circuit 408 when the lid is open. The access component 413 may have any suitable configuration and the HV component 400 may be enclosed within, at least partially covered by, or otherwise associated with the access component 413 that prevents premature access to the HV component 400 and to high-voltage power that may be passing through the component 400.

In the example of FIG. 4, the first signal generator 425 is reconfigured to be disconnected from the signal continuity detection circuit 408, to allow the HV component 400 fit the configuration of the centralized HVIL system 406 of the vehicle 102.

In accordance with some examples of the present disclosure, the first signal generator 425 may be reconfigured to be connected to the signal continuity detection circuit which allows interchangeably using the first signal generator 425 in a vehicle deploying an HVIL system of a de-centralized type. **FIG. 5** illustrates an example of a vehicle 103 which comprises the HV component 400 that has been reconfigured i.e. its first signal generator 425 is reconfigured to be connected to the signal continuity detection circuit 408. The vehicle 103 comprises a de-centralized HVIL system 506, similar to de-centralized HVIL system 306 of FIG. 3. Details of the implementation of the HV component 400 are not repeated in connection with the description of FIG. 5.

As shown schematically in FIG. 5, the first signal generator 425 may be connected to the signal continuity detection circuit 408 by, for example, allowing wires 529, shown by a dotted line, to be connected. For example, in some implementations, before the first signal generator 425 is installed on a vehicle with a de-centralized HVIL system, such as e.g. the vehicle 103, a circuit loop comprising the first signal generator 425 will be open at an interface e.g. the signal communication interface 414. The wires 529 will need to be connected by e.g. a manufacturer of the vehicle 103, to close the loop in a configurations as shown in FIG. 5. In some examples, the wires 529 may be short-circuited on the vehicle, which may help eliminate possible internal fault codes.

In the example of FIG. 5, when the continuity of the signal is breached, the internal HVIL system 404 is configured to generate and send a message 530 to the vehicle 103 e.g. to a master ECU 502, the message 530 informing the vehicle 103 of the breach of the continuity of the signal. As shown in FIG. 5, the vehicle 103 sends an instruction 532 to the HV component 400 in response to the message 530, wherein the instruction 532 may instruct the HV component 500 to shut down power, e.g., high-power or high-voltage current, supplied to the HV component 500. The master ECU 502 may comprise at least one processor and memory comprising computer-executable instructions that can be executed by the at least one processor. The ECU 502 may be or may comprise, e.g., a general-purpose processor, an application-specific processor, a circuit with processing components, a distributed group of processing components, a distributed group of computers configured for processing, a field programmable gate array (FPGA), or the like. The ECU 502 may be included in a controller or control system of the vehicle 102 that comprises various other components.

Accordingly, in examples herein, the high-voltage component is reconfigurable to be included in a centralized HVIL system or reconfigurable to be included in a de-centralized HVIL system. This advantageously allows manufacturing a modular, reconfigurable high-voltage or traction voltage device or component that may be used in either a vehicle with a centralized HVIL system or a vehicle with a de-centralized HVIL system. Thus, a need to manufacture at least two types of each HV vehicle component may be eliminated, which reduces manufacturing time and costs. Moreover, a reconfigurable HV component may be easier to install, maintain, and repair, which further improves vehicle manufacturing and maintenance process.

In some aspects, examples of the present disclosure provide a high-voltage (HV) component assembly of a vehicle, the high-voltage component assembly comprising at least one high-voltage (HV) component configured in accordance with examples of the present disclosure. The high-voltage component assembly may comprise one or more HV components.

In some examples, the HV assembly may comprise an external Hazardous Voltage Interlock Loop (HVIL) system comprising an external signal continuity detection circuit configured to electrically couple to an internal signal continuity detection circuit of each of the at least one HV component. FIGs. 2 and 4, as well as FIG. 1A, illustrate examples of vehicles which may include such HV assembly.

In some aspects, examples of the present disclosure provide a vehicle comprising at least one HV component configured in accordance with examples of the present disclosure. The vehicle may be any of the vehicles shown in FIGs. 1A, 1B, 4, and 5, as well as any other vehicle configured to include an HVIL system configured to monitor integrity of a high-power or high-voltage system in the vehicle.

In some aspects, examples of the present disclosure provide a vehicle comprising a HV component assembly in accordance with examples of the present disclosure. The vehicle may be any of the vehicles shown in FIGs. 1A, 1B, 4, and 5, as well as any other vehicle configured to include an HVIL system configured to monitor integrity of a high-power or high-voltage system in the vehicle.

In some aspects, examples of the present disclosure provide a method for configuring a high-voltage component for a vehicle. Non-limiting examples of a vehicle are shown in FIGs. 1B and 5, wherein the vehicles comprise a de-centralized HVIL system. The method comprises configuring the HV component so that a first signal generator of an internal HVIL system of the HV component is connected to a signal continuity detection circuit of the internal HVIL system, wherein the first signal generator is configured to generate a signal for the signal continuity detection circuit, wherein the first signal generator is reconfigurable to be non-functional and disconnected from the signal continuity detection circuit, and wherein the signal continuity detection circuit comprises a HV connector that enables a signal detector to detect when a continuity of the signal continuity detection circuit is breached.

In some examples, the method further comprises removing the high-voltage component from the vehicle and installing the high-voltage component on another vehicle which comprises reconfiguring the first signal generator to be non-functional and disconnected from the signal continuity detection circuit; and connecting the signal continuity detection circuit of the internal HVIL system to an external HVIL system, so that the signal continuity detection circuit receives the signal from a second signal generator of the external HVIL system. In this way, the HV component may be moved from the vehicle with the de-centralized HVIL system to the vehicle with a centralized HVIL system.

In some aspects, examples of the present disclosure provide another method for configuring a high-voltage component for a vehicle. Non-limiting examples of a vehicle are shown in FIGs. 1A and 4, wherein the vehicles comprise a centralized HVIL system. The method comprises configuring the HV component so that a first signal generator of an internal HVIL system of the HV component is disconnected from a signal continuity detection circuit of the internal HVIL system and is non-functional, wherein the first signal generator is reconfigurable to be connectable to the signal continuity detection circuit, and wherein the signal continuity detection circuit comprises a high-voltage connector that enables a signal detector to detect when a continuity of the signal continuity detection circuit is breached; and connecting the signal continuity detection circuit of the internal HVIL system to an external HVIL system, so that the signal continuity detection circuit receives the signal from a second signal generator of the external HVIL system.

In some examples, the method further comprises removing the high-voltage component from the vehicle and installing the high-voltage component on another vehicle which comprises reconfiguring the first signal generator of the internal HVIL system to be connected to the signal continuity detection circuit so that the first signal generator is functional and generates a signal for the signal continuity detection circuit of the internal HVIL system. In this way, the HV component may be moved from the vehicle with the centralized HVIL system to the vehicle with a de-centralized HVIL system.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the inventive concepts being set forth in the following claims.

## Claims

1. A high-voltage component (400) for a vehicle (102, 103), comprising:
an internal Hazardous Voltage Interlock Loop, HVIL, system (404), comprising:
a signal continuity detection circuit (408), comprising:
a signal detector (410) configured to detect a value of a signal in the signal continuity detection circuit; and
a high-voltage connector (412) that includes a signal path that is interrupted when a continuity of the signal in the signal continuity detection circuit is breached; and
a first signal generator (425) that is configured to generate a signal in the signal continuity detection circuit and that is reconfigurable to either be connected to or disconnected from an external HVIL system; and
a signal communication interface (414) configurable to provide an electrical connection between the signal continuity detection circuit of the internal HVIL system and the external HVIL system, and configurable to allow the first signal generator to be disconnected from the signal continuity detection circuit.

2. The high-voltage component of claim 1, wherein the signal detector is configured to be connected to an external interlocked circuit of the external HVIL system to receive a signal from a second signal generator located in the external interlocked circuit.

3. The high-voltage component of claim 1 or 2, wherein the high-voltage connector comprises a signal connector and a power connector, wherein the signal connector is configured to be opened before the power connector is opened.

4. The high-voltage component of any one of claims 1 to 3, wherein the high-voltage component comprises a fuel cell system.

5. The high-voltage component of any one of claims 1 to 4, wherein the signal continuity detection circuit comprises at least one additional signal detector (416, 418).

6. The high-voltage component of claim 5, wherein the at least one additional signal detector (416, 418) is configured to detect which one of at least two high-voltage components including the high-voltage component, connected to the external HVIL system, is causing the breach of the continuity of the signal.

7. The high-voltage component of any one of claims 1 to 6, comprising an access component that is configured to cause the continuity of the signal in the signal continuity detection circuit be breached when the access component is moved from a first configuration to a second configuration.

8. The high-voltage component of any one of claims 1 to 7, wherein, when the first signal generator is reconfigured to be connected to the signal continuity detection circuit, and when the continuity of the signal is breached, the internal HVIL system is configured to generate and send a message to the vehicle, the message informing the vehicle of the breach of the continuity of the signal.

9. The high-voltage component of claim 8, wherein the internal HVIL system is configured to receive, in response to the message, an instruction from the vehicle regarding an action responsive to the breach of the continuity of the signal.

10. The high-voltage component of any one of claims 1 to 9, wherein the high-voltage component is reconfigurable to be included in a centralized HVIL system or reconfigurable to be included in a de-centralized HVIL system.

11. A high-voltage component assembly of a vehicle, the high-voltage component assembly comprising at least one high-voltage component of any one of claims 1 to 10.

12. The high-voltage component assembly of claim 11, comprising an external Hazardous Voltage Interlock Loop, HVIL, system comprising an external signal continuity detection circuit configured to electrically couple to an internal signal continuity detection circuit of each of the at least one high-voltage component.

13. A vehicle comprising at least one high-voltage component of any one of claims 1 to 10 or a high-voltage component assembly of claim 11 or 12.

14. A method for configuring a high-voltage component for a vehicle, the method comprising:
configuring the high-voltage component so that a first signal generator of an internal Hazardous Voltage Interlock Loop, HVIL, system of the high-voltage component is connected to a signal continuity detection circuit of the internal HVIL system, wherein the first signal generator is configured to generate a signal for the signal continuity detection circuit, wherein the first signal generator is reconfigurable to be non-functional and disconnected from the signal continuity detection circuit, and wherein the signal continuity detection circuit comprises a high-voltage connector that enables a signal detector to detect when a continuity of the signal continuity detection circuit is breached.

15. A method for configuring a high-voltage component for a vehicle, the method comprising:
configuring the high-voltage component so that a first signal generator of an internal Hazardous Voltage Interlock Loop, HVIL, system of the high-voltage component is disconnected from a signal continuity detection circuit of the internal HVIL system and is non-functional, wherein the first signal generator is reconfigurable to be connectable to the signal continuity detection circuit, and wherein the signal continuity detection circuit comprises a high-voltage connector that enables a signal detector to detect when a continuity of the signal continuity detection circuit is breached; and
connecting the signal continuity detection circuit of the internal HVIL system to an external HVIL system, so that the signal continuity detection circuit receives the signal from a second signal generator of the external HVIL system.
